# EUROPEAN PATENT APPLICATION

(11) **EP 4 498 425 A1**
(43) Date of publication of application: **29.01.2025**
(21) Application number: 24188558.1
(22) Date of filing: 15.07.2024
(51) Int. Cl.: H01L 21/8258, H01L 27/06, H01L 27/085, H01L 21/02

(54) **SEMICONDUCTOR ELECTRONIC DEVICE INTEGRATING AN ELECTRONIC COMPONENT BASED ON HETEROSTRUCTURE AND HAVING REDUCED MECHANICAL STRESS**

(30) Priority: 27.07.2023 IT 202300015828
(71) Applicant: STMicroelectronics International N.V., 1228 Plan-les-Ouates, Geneva (CH)
(72) Inventor: DEPETRO, Riccardo, 28845 DOMODOSSOLA (VB) (IT)
(74) Representative: Studio Torta S.p.A.

(57) **Abstract**

A semiconductor electronic device (1) has a substrate region (10) of semiconductor material; a first electronic component (7) based on heterostructure, which has an epitaxial multilayer (49) that extends on the substrate region and includes a heterostructure (50); and a separation region (70) that extends on the substrate region. The separation region includes a polycrystalline region (73A, 73B) of semiconductor material of polycrystalline type which is arranged, along a first direction (X, Y), alongside the epitaxial multilayer. The electronic device also has an epitaxial region (23) of a single semiconductor material of monocrystalline type which extends on the substrate region (10). The polycrystalline region extends, along the first direction (X), between the epitaxial multilayer (49) and the epitaxial region (23).

## Description

### Technical Field

The present invention relates to a semiconductor electronic device integrating an electronic component based on heterostructure and having reduced mechanical stress. The present invention also relates to a manufacturing process of the semiconductor electronic device.

### Background

Semiconductor electronic devices are known which comprise active and/or passive electronic components based on silicon, for example CMOS, DMOS, BJT transistors, diodes, resistors, etc., integrated in a same silicon die and made for example using BCD (Bipolar-CMOS-DMOS) technology.

In practice, the functioning of these electronic components is based on the electronic properties of a single semiconductor material (silicon).

These devices monolithically integrate, in the same die, digital circuits, analog circuits and power circuits that work at voltages very different from each other, for example from a few volts in the case of CMOS transistors used for implementing logic functions up to hundreds of volts in the case of DMOS transistors used for power applications.

The silicon-based electronic components are integrated into a monocrystalline silicon region grown on a <100> silicon wafer.

Also known are semiconductor electronic devices comprising heterostructure-based electronic components, for example HEMT transistors.

In practice, the functioning of these electronic components is based on the electronic properties of a heterojunction between two different semiconductor materials.

In detail, in HEMT transistors, the conductive channel is based on the formation of layers of two-dimensional electron gas (2DEG) with high mobility which form at a heterojunction, i.e. at the interface between semiconductor materials having different band gap. For example, HEMT devices are known based on the heterojunction between an aluminum gallium nitride (AlGaN) layer and a gallium nitride (GaN) layer.

HEMT devices, in particular based on AlGaN/GaN heterostructures or heterojunctions, offer various advantages that make them particularly suitable and widely used for different applications. For example, the high breakdown threshold of HEMT devices is exploited for high-performance power switches; the high mobility of the electrons in the conductive channel allows high-frequency amplifiers to be formed; furthermore, the high concentration of electrons in the 2DEG allows a low ON-state resistance (R_{ON}) to be obtained.

Furthermore, HEMT devices for radio frequency (RF) applications typically have better RF performances than similar silicon LDMOS devices.

The heterostructure-based electronic components are integrated into a heterostructure grown epitaxially on a <111> silicon wafer, or on a sapphire (Al₂O₃) or silicon carbide (SiC) substrate.

The Applicant has observed that the growth of a heterostructure on a silicon wafer may cause high mechanical stress in the silicon wafer, due to the different lattice pitch between the growth substrate (silicon) and the materials forming the heterostructure (for example, GaN/AlGaN) .

The high mechanical stress may cause dislocations in the silicon wafer.

Dislocations may compromise the mechanical stability of the silicon wafer on which the heterostructure-based electronic components are formed. Consequently, the heterostructure-based electronic components are subject to breakdown, during manufacturing and in use.

Furthermore, in presence of electronic components based on silicon and integrated into the silicon wafer, the high mechanical stress and dislocations may compromise the mechanical stability and performances of the components based on silicon.

Consequently, heterostructure-based electronic components and silicon-based electronic components are integrated into dice distinct from each other, starting from two different silicon wafers.

However, this entails that an electronic apparatus that incorporates both silicon-based components and heterostructure-based components has a high area occupation and therefore a high manufacturing cost, high power consumption and low electrical performances, for example due to the parasitic capacitances or inductances introduced by the electrical connections between dice.

According to one approach, the die wherein the silicon-based components are formed and the die wherein the heterostructure-based components are formed are bonded on each other through a die transfer technology.

However, even this approach has disadvantages in terms of costs and manufacture and electrical performance reliability, in use.

### Summary

According to the present invention a semiconductor electronic device and a manufacturing process of a semiconductor electronic device are therefore provided, as defined in the attached claims.

### Brief Description of the Drawings

For a better understanding of the present invention, embodiments thereof are now described, purely by way of nonlimiting example, with reference to the attached drawings, wherein:
- Figure 1 shows a cross-section of a semiconductor electronic device, according to an embodiment;
- Figure 2 shows a top-plan view of the device of Figure 1;
- Figures 3A-3O show steps of a manufacturing process of the device of Figure 1, according to an embodiment;
- Figures 4 and 5 show top-plan views of a portion of the device of Figure 2, according to other embodiments; and
- Figures 6A and 6B show steps of a manufacturing process of a semiconductor electronic device, according to a different embodiment.

### Description of Embodiments

The following description refers to the arrangement shown in the accompanying Figures; consequently, expressions such as "above", "below", "lower", "upper", "right", "left", "high", "low", and the like, relate to the accompanying Figures and should not be interpreted in a limiting manner.

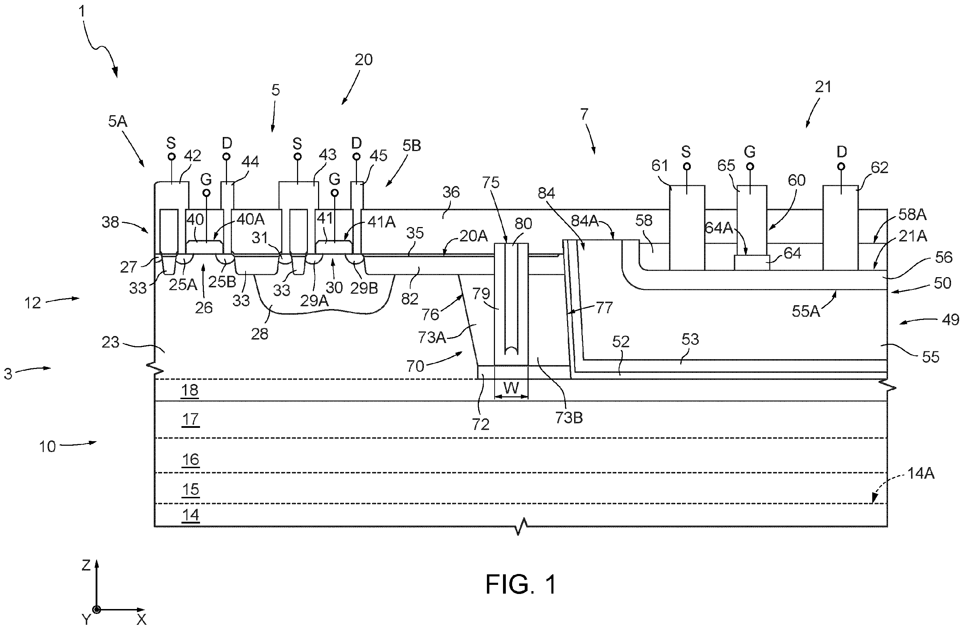

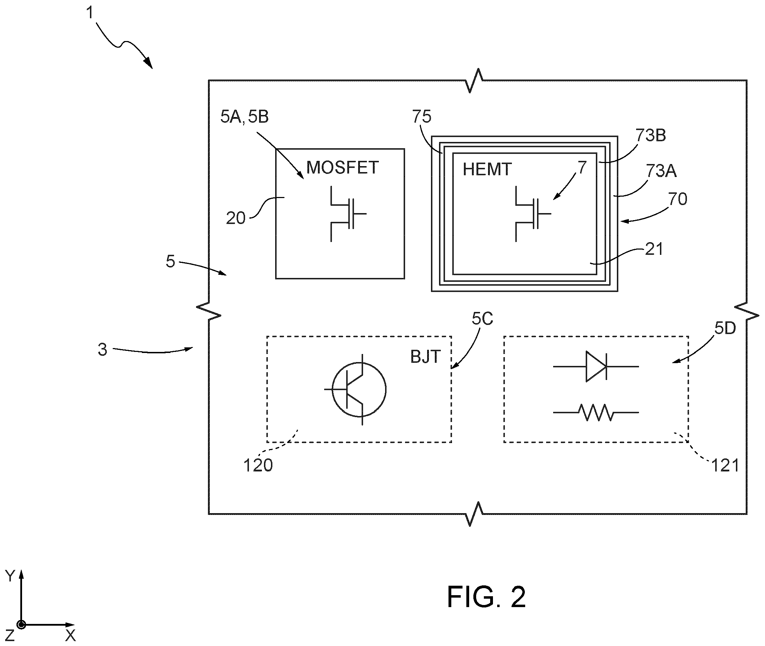

Figures 1 and 2 show a semiconductor electronic device (hereinafter simply referred to as device) 1, in a Cartesian reference system XYZ having a first axis X, a second axis Y and a third axis Z.

The device 1 is formed in a die 3 and comprises one or more silicon-based electronic components 5, of which a PMOS transistor 5A and a NMOS transistor 5B are shown in Figure 1, and one or more heterostructure-based electronic components, of which a HEMT transistor 7 is shown in Figure 1, all integrated in the die 3.

The die 3 comprises a substrate region 10 and a surface region 12 which extends on, in particular in direct contact with, the substrate region 10.

The substrate region 10 comprises a substrate 14 and one or more epitaxial layers arranged on the substrate 14.

The substrate 14 is of semiconductor material, in particular monocrystalline, and has an upper surface 14A.

In detail, in this embodiment, the substrate 14 is of monocrystalline silicon and, in particular, the upper surface 14A is oriented according to the <111> crystallographic direction.

In this embodiment, the substrate region 10 comprises a first epitaxial layer, or first deep layer 15, overlying the upper surface 14A of the substrate 14; a second epitaxial layer, or first intermediate layer 16, overlying the first deep layer 15; a third epitaxial layer, or second deep layer 17, overlying the first intermediate layer 16; and a fourth epitaxial layer, or second intermediate layer 18, overlying the second intermediate layer 17.

The epitaxial layers 15-18 are of semiconductor material, in particular the same as that of the substrate 14 (here of silicon), and are identified for the sake of clarity by dashed lines in Figure 1.

The thickness along the third axis Z, the conductivity type (for example, P or N) and the doping profile of the substrate 14 and of the epitaxial layers 15-18 may be chosen, at the design stage, according to the specific application of the device 1.

For example, the epitaxial layers 15-18 may each have a thickness comprised between 0.1 µm and 7 pm.

For example, in this embodiment, the substrate 14 is of P-type, for example with a resistivity comprised between 0.1 Ω·cm and 20 Ω·cm, and the epitaxial layers 15-18 are of N-type. In this manner, the first deep layer 15 may form a PN junction with the substrate 14 which, in use, may be used to insulate the devices 5, 7 integrated into the die 3 from the substrate 14.

The first and the second deep layers 15, 17 may have a doping level that is different, in particular higher, with respect to the first and the second intermediate layers 16, 18. For example, the doping level of the layers 15-18 may be such as to provide a resistivity comprised, for example, between 0.1 Ω·cm and 20 Ω·cm.

A high doping level of the first deep layer 15 causes, in use, the depleted region between first deep layer 15 and substrate 14 to extend mainly into the substrate 14, thus improving the electrical insulation of the components 5,7 from the substrate 14.

Furthermore, the high doping level of the first deep layer 15 may allow, in use, the first deep layer 15 to be used as current conduction region of the electronic components integrated into the die 3, for example if the silicon-based components 5 include BJT transistors.

The presence of both the first and the second deep layers 15, 17 may be useful to simplify the manufacture of the device 1 and to obtain, in use, excellent electrical performances of the device 1, in case the electronic components 5, 7 are designed to operate at high voltages with respect to the substrate 14, for example starting from about 60 V up to about 650 V, or even higher.

The surface region 12 extends on the second intermediate layer 18, in particular in direct contact therewith, and comprises a first device portion 20, wherein the PMOS 5A and NMOS 5B transistors are integrated, and a second device portion 21, wherein the HEMT transistor 7 is integrated.

The first device portion 20 has an upper surface 20A and comprises an epitaxial region 23 of monocrystalline semiconductor material, in particular of the same material as the second intermediate layer 18, here monocrystalline silicon.

The epitaxial region 23 extends from the second intermediate layer 18, in particular here in direct contact therewith, up to the upper surface 20A.

The thickness along the third axis Z, the conductivity type (for example, P or N) and the doping profile of the epitaxial region 23 may be chosen, at the design stage, according to the specific application of the device 1.

For example, in this embodiment, the epitaxial region 23 is of N-type.

The first device portion 20 comprises a plurality of doped regions which extend within the epitaxial region 23 and form functional regions of the silicon-based electronic components 5.

In practice, the silicon-based electronic components 5, here the PMOS 5A and NMOS 5B transistors, are integrated in the epitaxial region 23.

In detail, in the embodiment of Figure 1, doped regions 25A, 25B of P++ type extend within the epitaxial region 23 from the upper surface 20A. The doped regions 25A, 25B form the source region and, respectively, the drain region of the PMOS transistor 5A and delimit a channel region 26 of the PMOS transistor 5A.

Furthermore, a doped region 27 of N++ type extends in the epitaxial region 23 from the upper surface 20A and forms a body contact region of the PMOS transistor 5A.

Still with reference to the embodiment of Figure 1, a doped region 28 of P-type extends in the epitaxial region 23 from the upper surface 20A and forms the body region of the NMOS transistor 5B.

Doped regions 29A, 29B of N++ type extend within the doped region 28 and form the source region and, respectively, the drain region of the NMOS transistor 5B, and delimit a channel region 30 of the NMOS transistor 5B.

Furthermore, a doped region 31 of P++ type extends within the doped region 28 and forms a body contact region of the NMOS transistor 5B.

In practice, the doped regions 25A, 25B, 27, 29A, 29B and 31, i.e. the source, drain doped regions and the body contact regions, are highly doped regions, with a peak doping level comprised for example between 5·10¹⁹ cm⁻³ and 5·10²⁰ cm⁻³. Conversely, the doped region 28, i.e. the body region, is a low-doping region, with a doping level comprised for example between 1·10¹⁶ cm⁻³ and 2·10¹⁸ cm⁻³.

Number, arrangement, shape, size and doping profile of the doped regions may be chosen, at the design stage, according to the specific silicon-based electronic components 5 integrated in the die 3 and to the specific application of the device 1.

Insulating portions 33 of insulating material, for example of oxide, may extend, according to the specific application, within the epitaxial region 23 starting from the upper surface 20A.

In particular, in Figure 1, the insulating portions 33 extend, parallel to the first axis X, between the doped regions 27 and 25A, 25B and 31, 31 and 29A.

A first insulating layer 35, for example of oxide or nitride, extends on the upper surface 20A of the first device portion 20.

A second insulating layer 36, for example of oxide, extends on the first insulating layer 35.

Surface structures 38 of the silicon-based components 5, extend on the upper surface 20A of the first device region 20, in direct contact therewith. The surface structures 38 form further functional regions of the silicon-based devices 5 and may include various conductive and/or insulating regions, according to the specific silicon-based electronic components 5 integrated into the die 3.

In this embodiment, the surface structures 38 comprise gate insulated regions 40, 41 which respectively extend over the channel region 26 of the PMOS transistor 5A and over the channel region 30 of the NMOS transistor 5B. Of the gate insulated regions 40, 41, for the sake of simplicity, only the respective conductive regions, here of polysilicon and again indicated by 40, 41, are shown in Figure 1, each having a respective upper surface 40A, 41A.

Even if not shown in Figure 1, the gate insulated regions 40, 41 may each also comprise a respective insulating region arranged between the respective polysilicon region and the upper surface 20A and a respective contact region of conductive material, for example a metal, in contact with the respective surface 40A, 41A and forming a respective gate terminal G.

In the embodiment of Figure 1, the surface structures 38 also comprise source contact regions 42, 43 and drain contact regions 44, 45, of conductive material, which extend through the first and the second insulating layers 35, 36, in direct contact with the upper surface 20A, forming respective source S and drain D terminals.

In detail, the source contact regions 42, 43 extend in direct contact with the source region 25A of the PMOS transistor 5A and, respectively, the source region 29A of the NMOS transistor 5B.

Furthermore, in the embodiment shown, the source contact regions 42, 43 each extend in direct contact also with the respective body contact region 27, 31.

The drain contact regions 44, 45 extend in direct contact with the drain region 25B of the PMOS transistor 5A and, respectively, the drain region 29B of the NMOS transistor 5B.

The second device portion 21 of the surface region 12 has an upper surface 21A and comprises an epitaxial multilayer 49 extending on the second intermediate layer 18 and grown therefrom.

The epitaxial multilayer 49 comprises a heterostructure 50 wherein the HEMT transistor 7 is integrated.

In the embodiment of Figure 1, the epitaxial multilayer 49 also comprises a transition region formed here by a first and a second buffer layer 52, 53 overlying one another, which are arranged between the second intermediate layer 18 and the heterostructure 50. The transition region may be useful during the manufacture of the device 1 to favor the epitaxial growth of the heterostructure 50 on the second intermediate layer 18.

In detail, the first buffer layer 52, for example of aluminum nitride (AlN), extends on and in direct contact with the second intermediate layer 18, and the second buffer layer 53, for example of aluminum gallium nitride (AlGaN), extends on and in direct contact with the first buffer layer 52.

The heterostructure 50 comprises compound semiconductor materials including elements of group III and V of the periodic table and forms the upper surface 21A of the second device portion 21.

The upper surface 21A of the second device portion 21 may extend to a coordinate along the third axis Z equal to or different from that of the upper surface 20A of the first device portion 20, according to the specific manufacturing steps used for manufacturing the device 1.

In particular, in this embodiment, the upper surface 21A of the second device portion 21 is arranged at a lower height, measured along the third axis Z, with respect to the upper surface 20A of the first device portion 20. This may allow the manufacture of the device 1 to be improved.

The heterostructure 50 comprises a channel layer 55 and a barrier layer 56 overlying one another.

The channel layer 55 is of a first semiconductor material, for example gallium nitride (GaN) or an alloy comprising gallium nitride such as InGaN, here of gallium nitride (GaN), extends on the transition region, in particular on the second buffer layer 53, and has an upper surface 55A.

The barrier layer 56 is of a second semiconductor material, for example a compound based on a ternary or quaternary gallium nitride alloy, such as AlₓGa₁₋ₓN, AlInGaN, InₓGa₁₋ₓN, AlₓIn₁₋ₓAl, AlScN, here of aluminum gallium nitride (AlGaN), extending between the upper surface 55A of the channel layer 55 and the upper surface 21A of the second device portion 21.

The channel layer 55 and the barrier layer 56 may be of intrinsic, P or N type, according to the specific application; in particular, both the channel layer 55 and the barrier layer 56 may be of N-type.

For example, when the barrier layer 56 is of AlGaN, the presence of aluminum atoms may cause the barrier layer 56 to be of N-type.

The heterostructure 50 is configured to accommodate a two-dimensional gas (2DEG) of (mobile) charge carriers, in particular here of electrons, which is arranged at the interface between the channel layer 55 and the barrier layer 56, i.e. at the upper surface 55A of the channel layer 55.

An insulating layer 58 having an upper surface 58A, for example of an oxide such as silicon oxide, extends on the upper surface 21A, for example with a thickness comprised between 20 nm and 1 pm.

The insulating layer 36 extends also on the second device portion 21, in particular on the insulating layer 58.

Surface structures 60 of the heterostructure-based components 7 extend on the upper surface 21A of the second device portion 21.

The surface structures 60 may be various conductive and/or insulating regions, according to the specific heterostructure-based electronic components 7 integrated in the die 3, which form functional regions of the heterostructure-based components 7.

In this embodiment, wherein the heterostructure-based electronic component 7 is a HEMT transistor, the surface structures 60 comprise a source region 61 and a drain region 62, of conductive material, extending at a distance from each other along the first axis X.

The source region 61 and the drain region 62 are in electrical contact, in particular ohmic contact, with the heterostructure 50, in particular with the two-dimensional gas forming at the interface between the channel layer 55 and the barrier layer 56, and form a source terminal S and, respectively, a drain terminal D of the HEMT transistor 7.

In the embodiment of Figure 1, the source and drain regions 61, 62 extend, parallel to the third axis Z, through the insulating layers 36, 58 up to the upper surface 21A.

However, the source and drain regions 61, 62 may extend, parallel to the third axis Z, also partially through the heterostructure 50, for example for part of the barrier layer 56 or throughout the thickness of the barrier layer 56 up to the surface 55A, according to the specific application.

The surface structures 60 also comprise a gate structure, herein formed by a channel modulation region 64 and a gate contact region 65, which may be biased to electrically control the formation of the two-dimensional gas in the heterostructure 50 between the source region 61 and the drain region 62. The gate structure forms a gate terminal G of the HEMT transistor 7.

In this embodiment, the HEMT transistor 7 is of the normally-off type, i.e. of the enhancement-type.

In detail, in this embodiment, the channel modulation region 64 is of semiconductor material and has a different conductivity type with respect to the barrier layer 56, for example of P-type. In particular, the channel modulation region 64 may be of P-type gallium nitride (p-GaN).

However, the channel modulation region 64 may be of different material, for example of dielectric material, so as to obtain an insulated-type gate structure.

The channel modulation region 64 extends on the upper surface 21A, between the source region 61 and the drain region 62 along the first axis X, and has an upper surface 64A.

The upper surface 64A of the channel modulation region 64 may extend at a coordinate along the third axis Z equal to or different from that of the upper surface 40A, 41A of the gate insulated regions 40, 41, according to the specific manufacturing steps used for manufacturing the device 1.

In particular, in this embodiment, the upper surface 64A of the channel modulation region 64 is arranged at a distance from the second intermediate layer 18, measured along the third axis Z, smaller than the distance, measured along the third axis Z, of the upper surface 40A, 41A of the gate insulated regions 40, 41 from the second intermediate layer 18. This may allow the reliability of the manufacture of the device 1 to be increased.

The gate contact region 65, of conductive material, extends in electrical contact with the channel modulation region 64, in particular here in contact with the upper surface 64A.

The device 1 also comprises, in the surface region 12 of the die 3, a separation region 70 which extends on the substrate region 10, in particular on the second intermediate layer 18 in direct contact therewith, alongside the epitaxial multilayer 49.

With reference to the arrangement of Figures 1 and 2, the separation region 70 extends, parallel to the first axis X, between the epitaxial multilayer 49 and the epitaxial region 23.

In this embodiment, as visible in Figure 2, the separation region 70 surrounds the epitaxial multilayer 49.

In detail, the separation region 70 comprises a definition region 72, of a material different from that of the second intermediate layer 18, and a polycrystalline region, here formed by two polycrystalline portions 73A, 73B, of polycrystalline semiconductor material, in particular polycrystalline silicon.

The definition region 72 may be formed by a single layer, for example of oxide, in particular silicon oxide, or by a multilayer comprising for example one or more layers of an oxide and/or one or more layers of a nitride.

In detail, according to one embodiment, the definition region 72 may be of silicon oxide.

According to a different embodiment, the definition region 72 may comprise an oxide layer, in particular silicon oxide, and a nitride layer. According to one embodiment, the oxide layer may be in direct contact with the second intermediate layer 18.

The definition region 72 extends in direct contact with the second intermediate layer 18.

The definition region 72 may have a thickness along the third axis Z comprised for example between 7 nm and 300 nm, in particular between 70 Å and 200 Å.

The polycrystalline portions 73A, 73B extend on the definition region 72 and surround the epitaxial multilayer 49.

The separation region 70 further comprises a trench 75 which extends within the polycrystalline region, in particular here between the two polycrystalline portions 73A, 73B.

In detail, the trench 75 separates the two polycrystalline portions 73A, 73B from each other. In practice, in this embodiment, the two polycrystalline portions 73A, 73B are distinct from each other and extend at a distance from each other.

The trench 75 has a width W, measured between the two polycrystalline portions 73A, 73B, which may be comprised between 0.2 µm and 3µm (wherein the boundaries may be included or excluded).

The polycrystalline portion 73A extends externally to the trench 75 and, in this embodiment, is contiguous (monolithic) with the epitaxial region 23. In practice, the polycrystalline portion 73A forms an outer side wall 76 of the separation region 70.

The tilting of the outer side wall 76 may depend on the crystalline orientation of the epitaxial region 23 and on the thickness along the third axis Z of the definition region 75. For example, in case the epitaxial region 23 is oriented according to the <111> crystallographic direction, the outer side wall 76 may form an angle of about 54° with a direction parallel to the first axis X.

The polycrystalline portion 73B extends inside the trench 75, here in contact with the epitaxial multilayer 49. In practice, the polycrystalline portion 73B forms an inner side wall 77 of the separation region 70.

The tilting of the inner side wall 77 may depend on the specific manufacturing steps used to manufacture the epitaxial multilayer 49.

The trench 75 may be filled, partially or totally, or may be empty, according to the specific manufacturing steps used for manufacturing the device 1.

With reference to Figure 1, the trench 75 comprises a peripheral portion 79, formed by one or more of the materials which form the epitaxial multilayer 49, and a central portion 80 which may be empty or filled, totally or partially, with insulating material, for example of the same material that forms the insulating layer 36.

In this embodiment, the polycrystalline portions 73A, 73B extend at a distance from the upper surface 20A. In detail, an insulation region 82 of insulating material, for example of oxide, extends in the die 3, from the upper surface 20A towards the inside of the epitaxial region 23 and the separation region 70.

In the embodiment of Figure 1, the epitaxial multilayer 49 comprises a peripheral portion 84 which extends, conformally, on the inner side wall 77 of the separation region 70 and forms a raised surface 84A.

The raised surface 84A is arranged at a coordinate along the third axis Z greater with respect to the upper surface 21A and, here, even greater than the upper surface 58A of the insulating layer 58.

Furthermore, in this embodiment, the trench 75 extends, along the third axis Z, also through the insulation region 82, up to a coordinate along the third axis Z greater than the upper surface 20A, in particular aligned with the raised surface 84A. However, shape and structure of the trench 75 depend on the specific manufacturing steps used.

The polycrystalline region of the separation region 70, here formed by the polycrystalline portions 73A, 73B, alongside the epitaxial multilayer 49, acts as a spacing region between the epitaxial multilayer 49 and the epitaxial region 23.

In fact, the presence of a polycrystalline region allows to absorb the mechanical stress caused by the different lattice pitch between the material that forms the epitaxial region 23 (here silicon) and the materials that form the heterostructure 50 (here AlN, GaN and AlGaN).

Consequently, the heterostructure 50 is subject laterally to low mechanical stress. The heterostructure 50 may thus have a good crystallographic quality and, consequently, the HEMT transistor 7 may have good electrical performances, in use.

The presence of the separation region 70 also causes the epitaxial region 23 to be subject to low mechanical stress and to low risk of dislocations. Silicon-based electronic components 5 may then be integrated into the epitaxial region 23.

Furthermore, the Applicant has verified that the presence of the trench 75 contributes to further reducing the mechanical stress alongside the epitaxial multilayer 49.

In practice, the device 1 may allow to combine, in a single die, the functionality of the silicon-based components 5 and the heterostructure-based components 7 , while maintaining small dimensions with respect to an electronic device wherein the silicon-based components 5 and the heterostructure-based components 7 are integrated on dice different from each other.

Furthermore, the electrical connection between the silicon-based components 5 and the heterostructure-based components 7 may be formed directly on the die 3. This may ensure high electrical performances, in use, of the device 1.

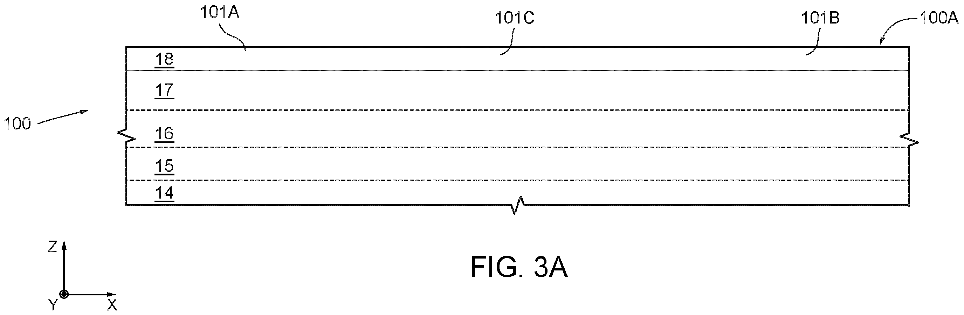

Hereinafter, with reference to Figures 3A-3O, manufacturing steps of the semiconductor electronic device 1 are described.

Figure 3A shows a cross-section of a wafer 100 of monocrystalline semiconductor material, in particular silicon, having an upper surface 100A. Elements of the wafer 100 common to what has already been described with reference to Figure 1 are indicated with the same reference numbers and are not further described in detail.

The wafer 100 comprises the substrate 14 on which the epitaxial layers 15, 16, 17, and 18 have already been grown.

The fourth epitaxial layer, or second intermediate layer, 18 form the upper surface 100A of the wafer 100.

The second intermediate layer 18 comprises a first portion 101A whereon the epitaxial region 23 is intended to be formed, a second portion 101B whereon the epitaxial multilayer 49 in intended to be formed, and a third portion 101C whereon the separation region 70 in intended to be formed.

The first portion 101A, the second portion 101B and the third portion 101C are laterally arranged one with the other within the second intermediate layer 18, in particular laterally along the first axis X in the shown embodiment.

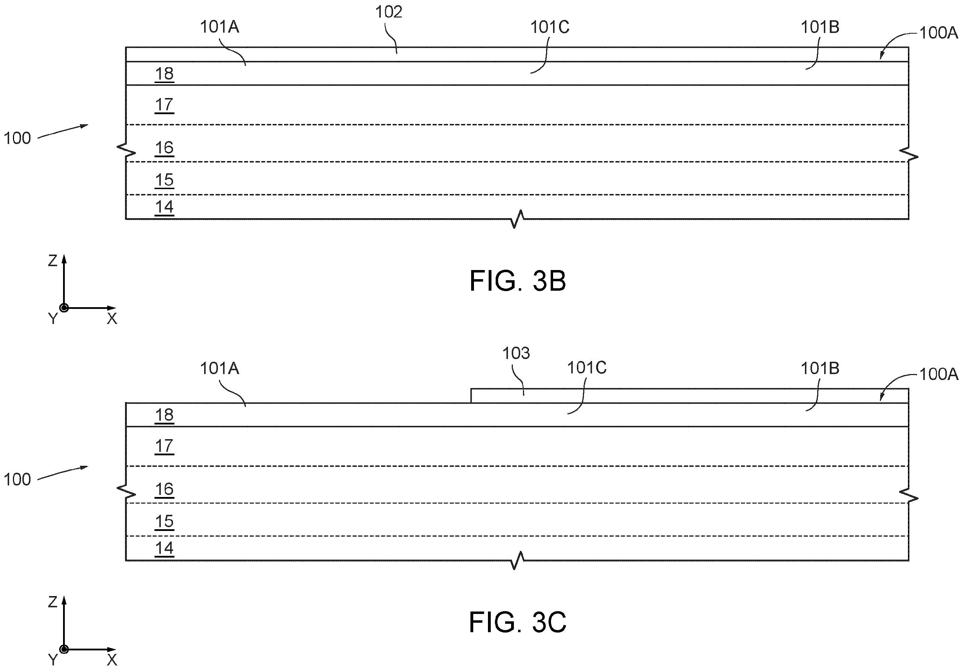

Subsequently, Figure 3B, a definition layer 102, comprising an oxide for example of silicon oxide, is formed on the upper surface 100A.

The definition layer 102 may be a single layer or a multilayer, as discussed for the definition region 72.

The definition layer 102 may have a thin thickness along the third axis Z, comprised for example between 7 nm and 300 nm, in particular between 70 Å and 200 Å.

The definition layer 102 is intended to form the definition region 72 (Figure 1).

The definition layer 102 may be formed by oxidation of a surface portion of the second intermediate layer 18, or by deposition on the upper surface 100A. In case of oxidation, the thickness of the second intermediate layer 18 may be reduced, following the oxidation, with respect to the layer 18 of Figure 3A. However, given the much smaller thickness of the definition layer 102 with respect to the thickness of the second intermediate layer 18, it may be assumed for the sake of simplicity that the thickness of the second intermediate layer 18 remains, as a first approximation, the same before and after the oxidation.

Then, Figure 3C, the definition layer 102 is removed at the first portion 101A of the second intermediate layer 18, i.e. the portion of the second intermediate layer 18 whereon the epitaxial region 23 is intended to be formed. Therefore, of the definition layer 102 a portion remains that is hereinafter also referred to as growth mask 103.

In practice, the growth mask 103 exposes the first portion 101A of the second intermediate layer 18 and covers the second and the third portions 101B, 101C of the second intermediate layer 18.

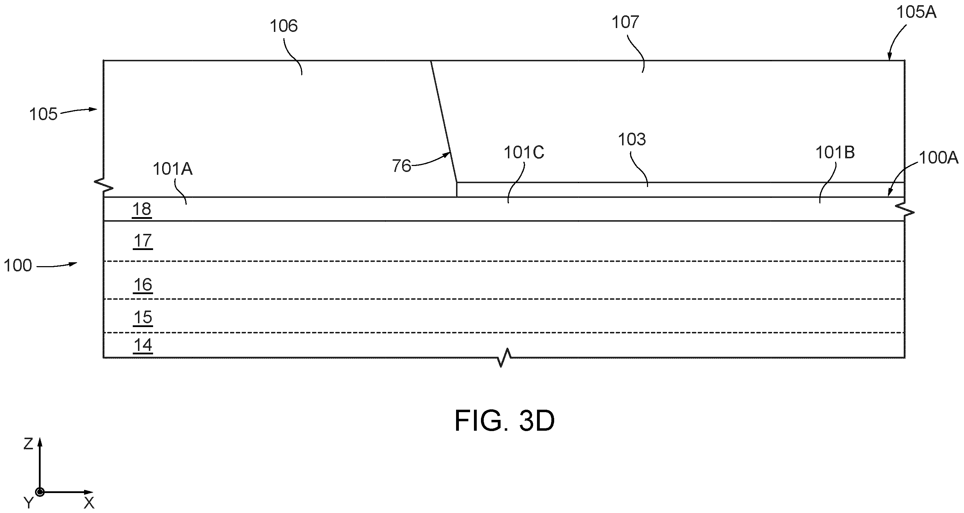

In Figure 3D, a surface layer 105 of semiconductor material, in particular of the same material as the second intermediate layer 18 (here silicon), is grown on the wafer 100.

The surface layer 105 has an upper surface 105A.

The surface layer 105 comprises an epitaxial portion 106 which grows parallel to the third axis Z from the second intermediate layer 18, in particular from the respective first portion 101A, and a sacrificial portion 107 which grows parallel to the third axis Z on the growth mask 103.

The epitaxial portion 106, which grows from a monocrystalline substrate, maintains the monocrystalline structure of the second intermediate layer 18 and is intended to form the epitaxial region 23.

The sacrificial portion 107, which grows from a non-crystalline substrate, has a polycrystalline structure.

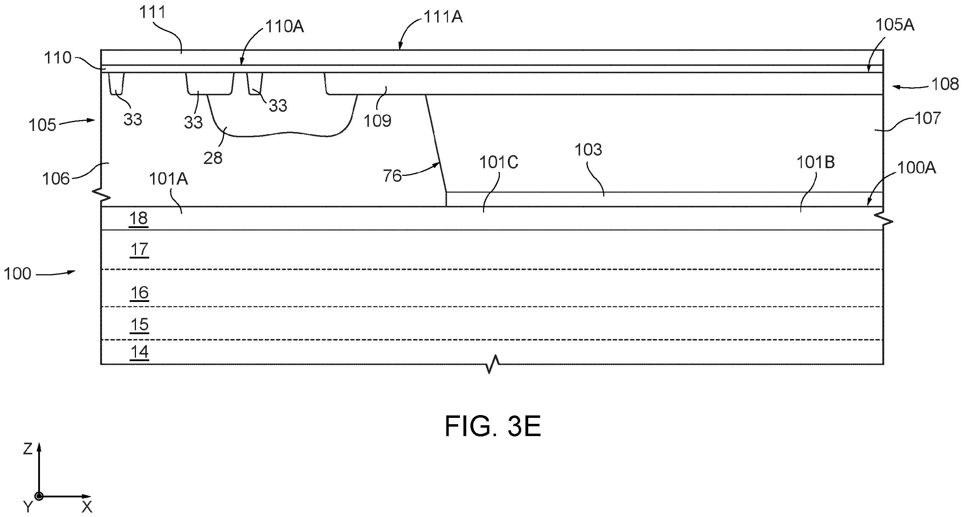

In Figure 3E, the doped region 28, corresponding to the body region of the NMOS transistor 5B, and, optionally, an insulating layer 108 are formed in the surface layer 105.

In detail, the body region 28 is formed in the epitaxial portion 106, where the silicon-based components 5 are formed.

The body region 28 may be formed by implantation of doping ions.

The insulating layer 108, for example of silicon oxide, forms the insulating portions 33 (Figure 1) and a portion 109 intended to form the insulation region 82 (Figure 1).

The insulating layer 108 may be formed by forming insulation trenches in the surface layer 105, for example Shallow Trench Isolation (STI). In this case, the thickness of the epitaxial portion 106 and of the sacrificial portion 107 may reduce in response to the formation of the insulating layer 108. The portion 109 may be continuous or formed by multiple structures disjoined from each other, for example by alternating dielectric zones having thicknesses different from each other.

Furthermore, still with reference to Figure 3E, one or more surface layers 110 may be formed on the upper surface 105A of the surface layer 105, according to the specific silicon-based electronic components 5 that it is desired to integrate in the die 3 of the device 1.

In the embodiment shown, the surface layers 110 are layers intended to form the gate insulated regions 40, 41 (Figure 1) of the PMOS and NMOS transistors 5A, 5B. In particular, of the surface layers 110 only a single gate layer, here of polysilicon, still indicated by 110, is shown here. However, an oxide layer, here not shown, is formed in a per se known manner between the upper surface 105A and the polysilicon layer 110.

The polysilicon layer 110 has an upper surface 110A.

A mask sacrificial layer 111 having an upper surface 111A, for example of insulating material, is also formed on the surface 110A of the gate layer 110. The mask sacrificial layer 111 may be a single layer or a multilayer, for example comprising silicon oxide, silicon nitride, aluminum oxide, and silicon carbide, or a combination thereof.

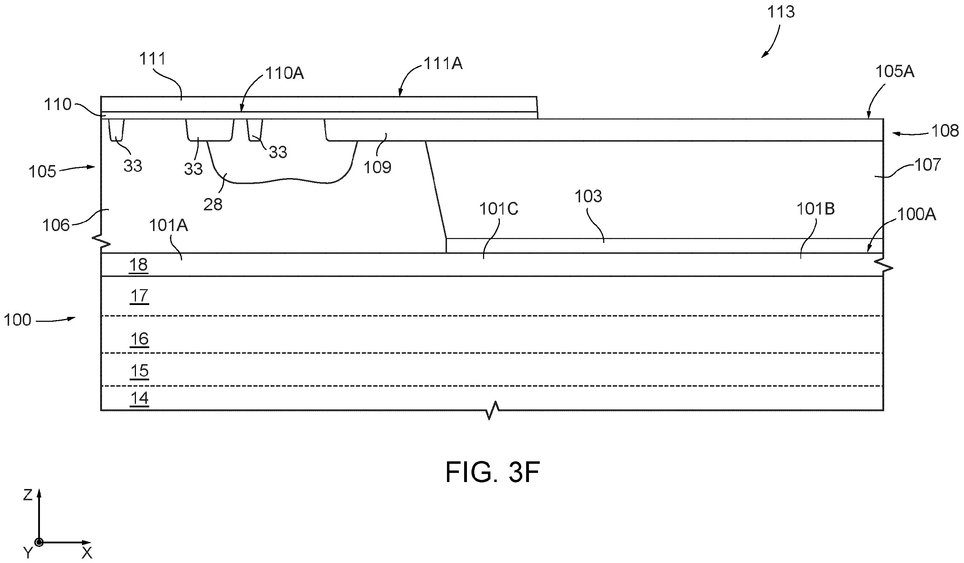

In Figure 3F, an opening 113 is opened over the sacrificial portion 107.

The opening 113 is formed by selectively removing part of the layers 110, 111, thus exposing the underlying sacrificial portion 107, in particular the part facing the second portion 101B of the second intermediate layer 18.

The remaining portion of the sacrificial layer 111 may be used as an etching mask.

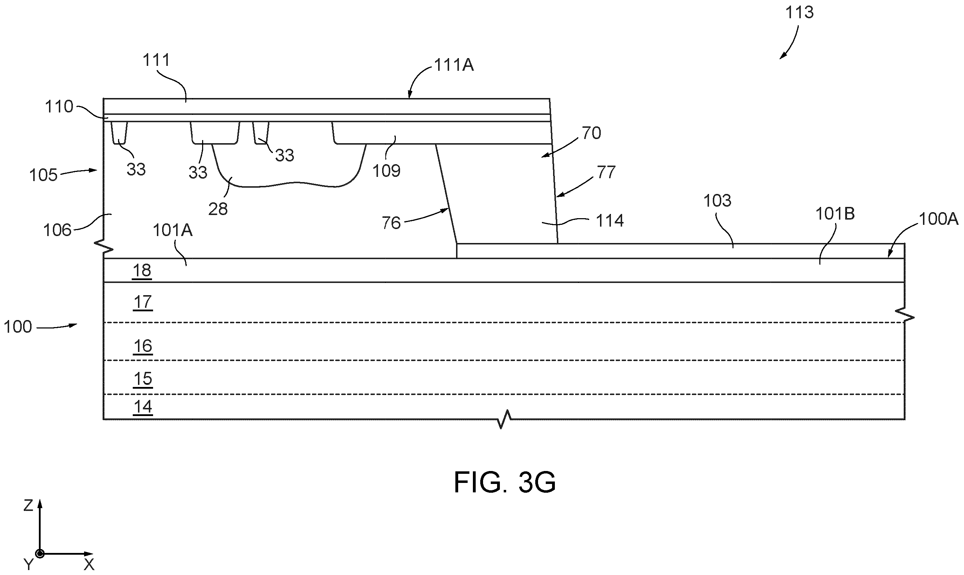

Subsequently, Figure 3G, the insulating layer 108 and the sacrificial portion 107 are removed at the opening 113, using the etching mask 111.

Therefore, of the sacrificial portion 107, there remains the portion (here indicated as work polycrystalline region 114) that is arranged below the etching mask, faces the third portion 101C of the second intermediate layer 18 and will form the polycrystalline portions 73A, 73B of Figure 1.

Upon the etching of Figure 3G, the recess formed in the sacrificial portion 107 is continuous with the opening 113 and exposes the part of the growth mask 103 which faces the second portion 101B of the second intermediate layer 18.

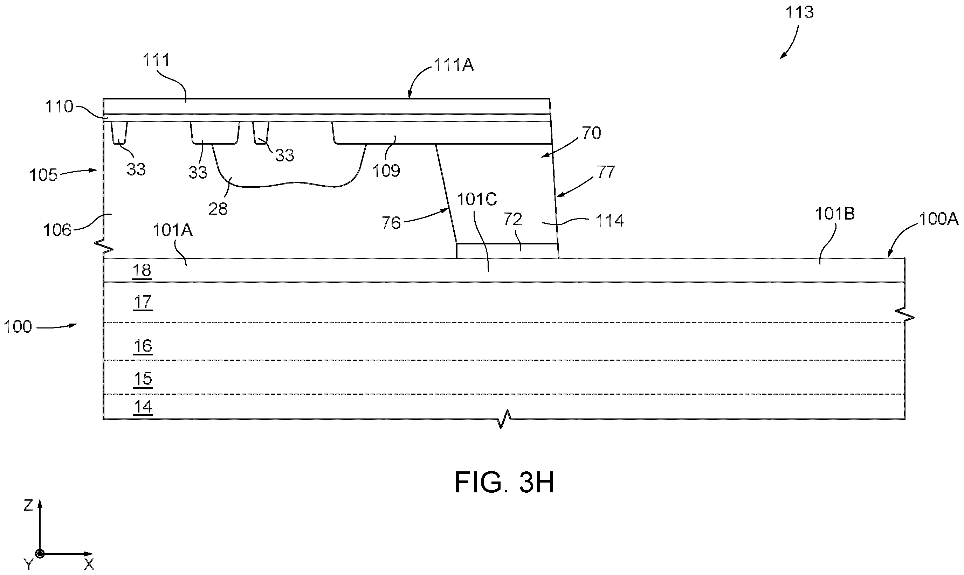

In Figure 3H, the exposed part of the growth mask 103 is removed. Therefore, of the growth mask 103, there remains the portion that is arranged below the work polycrystalline region 114, i.e. the definition region 72 of Figure 1.

The etching of the exposed part of the growth mask 103 may be performed using a selective chemistry that does not etch, as a first approximation, the underlying second intermediate layer 18.

Upon the etching of Figure 3H, the opening 113 therefore also exposes the second portion 101B of the second intermediate layer 18.

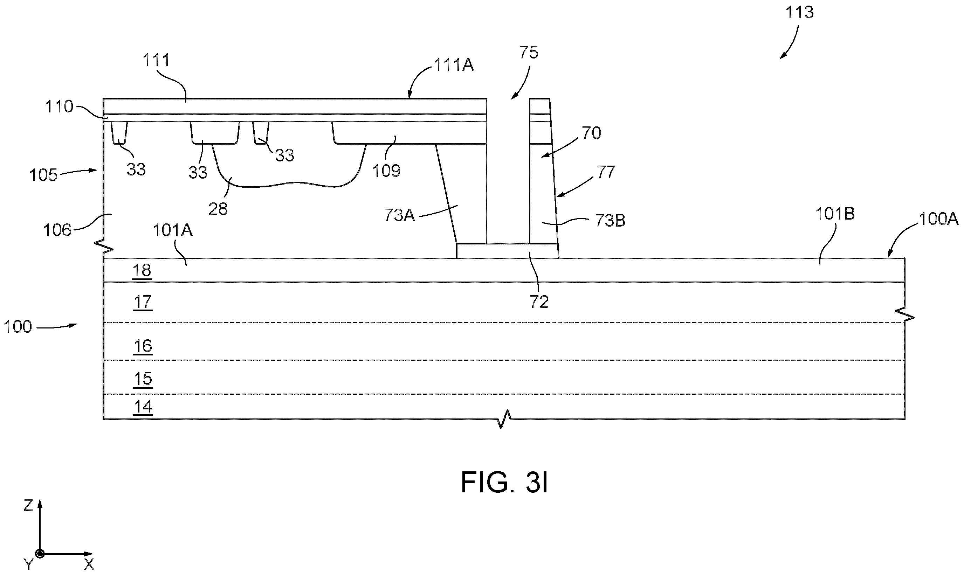

In Figure 3I, the trench 75 of Figure 1 is formed by opening a respective window in the etching mask 111 and removing an exposed portion of the work polycrystalline region 114. Therefore, of the work polycrystalline region 114, the polycrystalline portions 73A and 73B remain.

In this embodiment, the formation of the trench 75 also comprises the removal of part of the insulating layer 109.

The removal of the exposed portion of the work polycrystalline region 114 may be performed using the same chemistry used to form the recess 113 of Figure 3G.

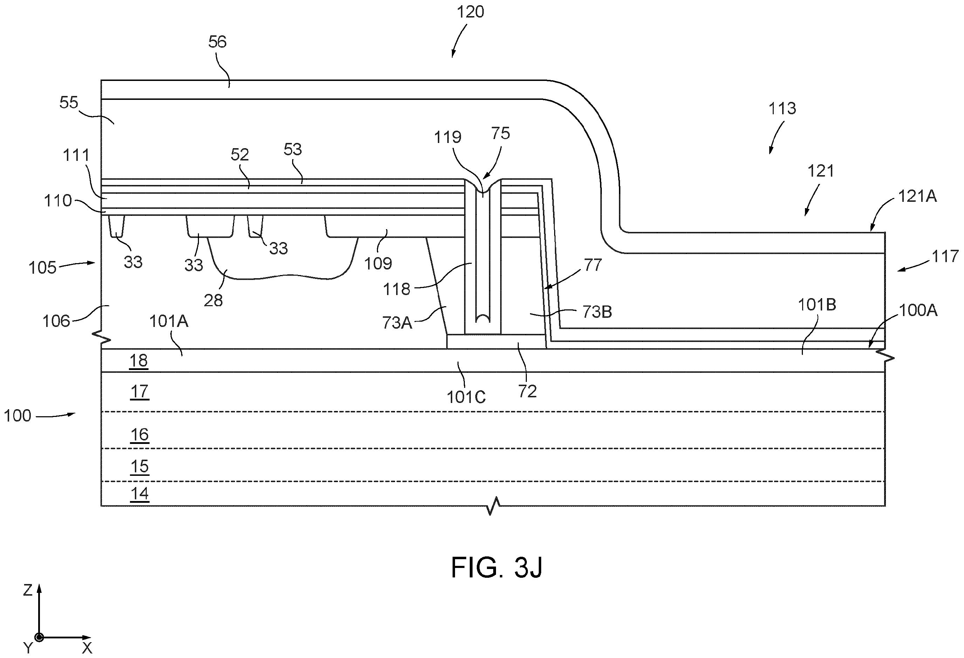

Then, Figure 3J, a work multilayer 117, intended to form the epitaxial multilayer 49 of Figure 1, is grown on the wafer 100.

In detail, a first buffer layer, corresponding to the buffer layer 52 of Figure 1 and therefore indicated by the same reference number, is grown on the wafer 100. The first buffer layer 52 extends on the exposed portion of the upper surface 100A, on the inner side wall 77 and on the etching mask 111.

A second buffer layer, corresponding to the buffer layer 53 of Figure 1 and therefore indicated by the same reference number, is grown on the first buffer layer 52.

A channel layer, corresponding to the channel layer 55 of Figure 1 and therefore indicated by the same reference number, is grown on the second buffer layer 53.

A barrier layer, corresponding to the barrier layer 56 of Figure 1 and therefore indicated by the same reference number, is grown on the channel layer 55.

In the embodiment shown, part of the work epitaxial multilayer 117 also grows within the trench 75, in particular here conformally to the walls of the trench 75, forming a filling portion 118 and leaving a central portion 119 of the trench 75 empty.

Without loss of generality, the filling portion 118 may be formed by one or more of the materials which form the work multilayer 117 (for example AlN, AlGaN and/or GaN) or other materials such as for example dielectrics or insulators such as for example oxides or silicon nitrides, aluminum oxide, etc., and the specific shape of the filling portion 118 may be different from what shown, according to the specific growth conditions used to grow the work multilayer 117.

In practice, the work multilayer 117 comprises, in addition to the filling portion 118, an elevated portion 120, which extends on the etching mask 111 and on the inner side wall 77 of the separation region 70, and a useful portion 121 which extends directly on the upper surface 100A of the second intermediate layer 18.

The useful portion 121 has an upper surface 121A which is substantially planar, in particular substantially parallel to the upper surface 100A.

The useful portion 121, grown on the second intermediate layer 18, is of monocrystalline type and is used to integrate the heterostructure-based devices 7.

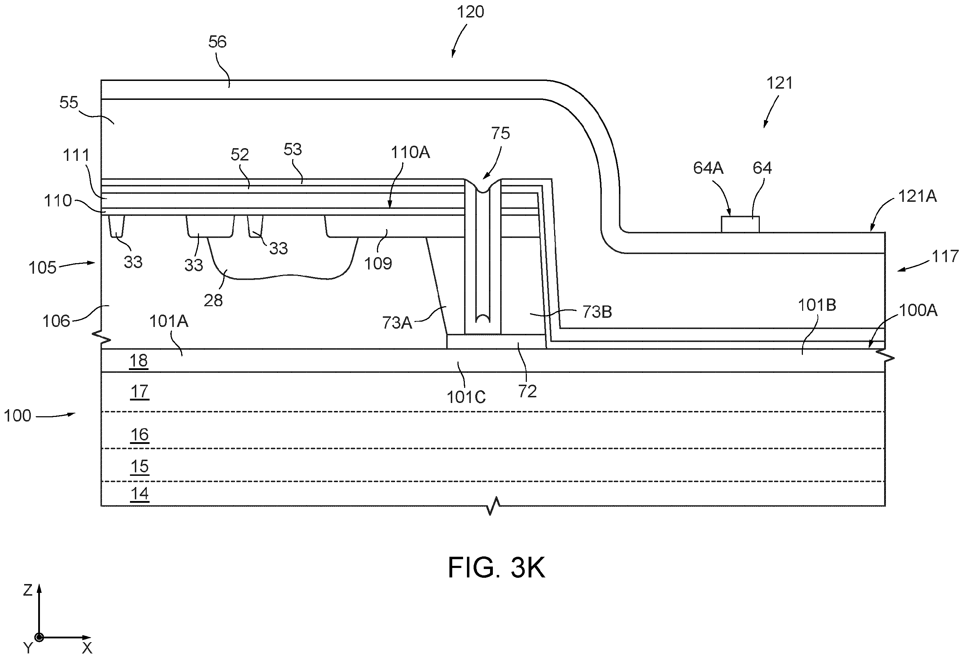

Then, Figure 3K, the channel modulation region 64 is formed, in a per se known manner, for example by growing and defining a specific layer, on the upper surface 121A of the useful portion 121.

In practice, in this embodiment, the useful portion 121 of the work multilayer 117 also comprises the channel modulation region 64.

Thus, here, the surface 64A of the modulation region 64 forms the most elevated surface of the useful portion 121, i.e. the surface of the useful portion 121 at the greatest distance along the third axis Z from the surface 100A.

The surface 110A on which the etching mask 111 extends may be arranged at a distance, along the third axis Z, from the surface 100A, greater than the most elevated surface of the useful portion 121. This may be useful in the subsequent manufacturing steps to protect the channel modulation region 64 and therefore increase the reliability of the manufacturing process of the device 1.

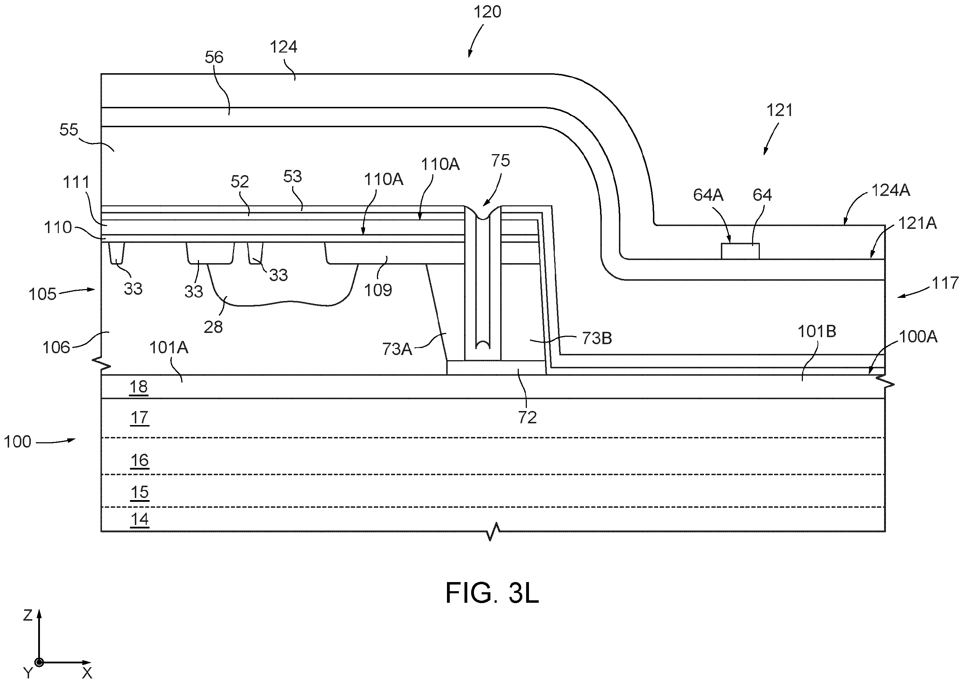

A protective layer 124 of insulating material, for example a single layer or a multilayer, for example comprising silicon oxide, silicon nitride, aluminum oxide, silicon carbide or a combination thereof, is formed, Figure 3L, on the barrier layer 56. The protective layer 124 has a thickness, along the third axis Z, for example comprised between 10 nm and 500 nm, greater than that of the channel modulation region 64.

In other words, the protective layer 124 completely covers the channel modulation region 64.

The protective layer 124 has, at the useful portion 121, an upper surface 124A which faces the upper surface 121A of the useful portion 121.

In this embodiment, the upper surface 124A of the protective layer 124 extends at a height, along the third axis Z from the surface 100A, that is lower than the height, along the third axis Z from the surface 100A, of the upper surface 111A of the etching mask 111. This may be useful in the subsequent manufacturing steps to protect the channel modulation region 64 and therefore increase the reliability of the manufacturing process of the device 1.

Furthermore, in this embodiment, the distance along the third axis Z between the upper surface 124A of the protective layer 124 and the upper surface 64A of the channel modulation region 64 is greater than the thickness, along the third axis Z, of the etching mask 111. This may be useful in the subsequent manufacturing steps to protect the channel modulation region 64 and therefore increase the reliability of the manufacturing process of the device 1.

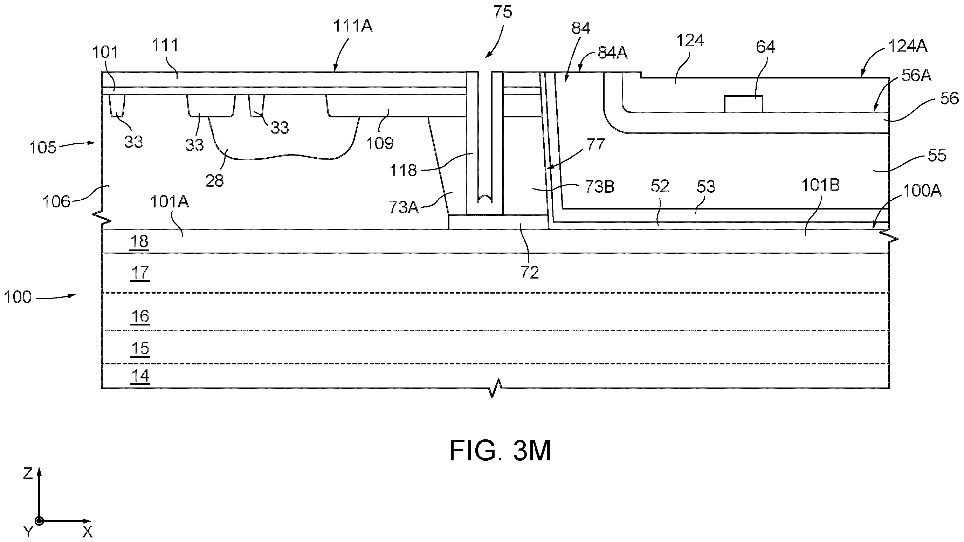

In Figure 3M, the elevated portion 120 of the work multilayer 117 is removed, at least in part, up to the upper surface 111A of the etching mask 111, thus exposing the etching mask 111.

The removal may be performed by planarization, for example chemical-mechanical polishing (CMP) or other etching techniques.

In the embodiment shown, following upon the removal of the elevated portion 120, of the work multilayer 117 there remains only the part extending on the inner side wall 77, which forms the peripheral portion 84 of the multilayer 49 (Figure 1), whose surface 84A is level with the upper surface 111A of the etching mask 111.

Of the protective layer 124, there remains the portion, still indicated by 124, that extends on the useful portion 121 of the work multilayer 117.

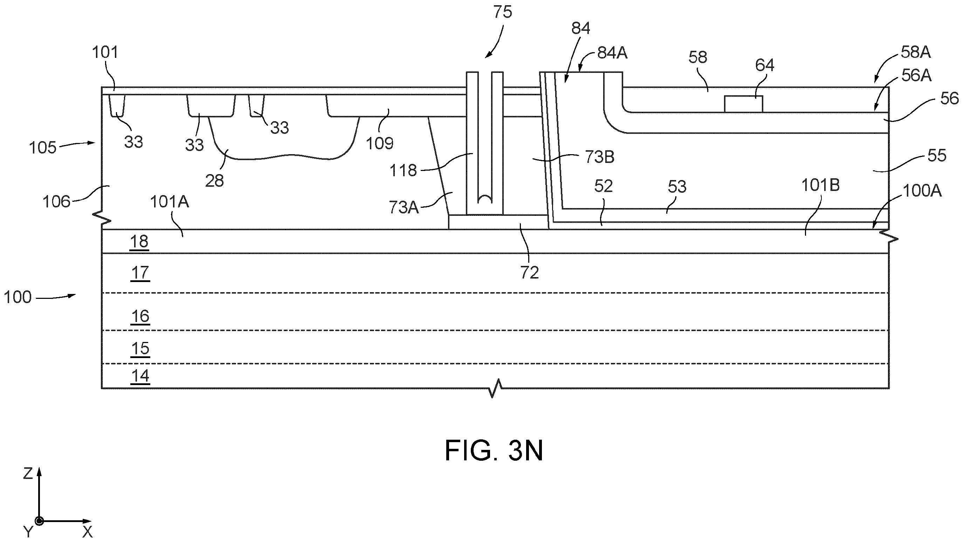

Then, Figure 3N, the wafer 100 is etched so as to remove the etching mask 111 and thus expose the gate layer 110.

In this embodiment, the etching of the etching mask 111 also etches the protective layer 124, thus reducing its thickness. However, since the thickness of the etching mask 111 is smaller than the distance between the upper surface 64 of the channel modulation region 64 and the upper surface 124A of the protective layer 124, the remaining protective layer 124 still completely covers the channel modulation region 64. Consequently, the channel modulation region 64 cannot be damaged by the etching of Figure 3N.

Upon etching, the protective layer 124 forms the insulating layer 58 described with reference to Figure 1.

According to the materials forming the etching mask 111 and the protective layer 118 and to the specific etching used to remove the etching mask 111, the etching of Figure 3N may selectively remove only the etching mask 111 and not the protective layer 124.

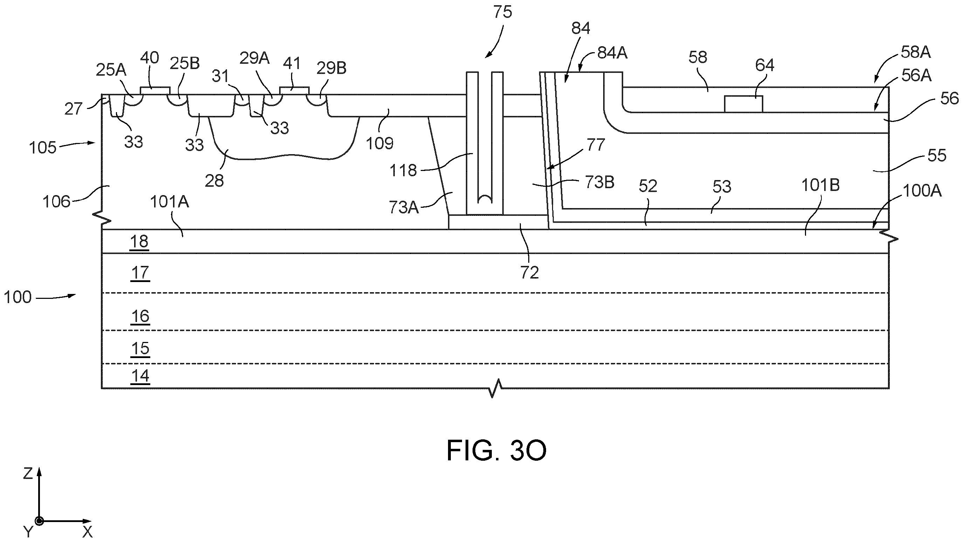

Subsequently, Figure 3O, the gate layer 110 is defined thus forming the gate insulated regions 40, 41. Furthermore, the (highly) doped regions 25A, 25B, 27, 29A, 29B, 31 are formed within the epitaxial portion 106 of the surface layer 105, for example through subsequent masking and ion implantation steps, according to the specific application.

Manufacturing steps follow, here not shown, for forming insulation and/or passivation layers of the wafer 100 (for example the oxide layers 35, 36 of Figure 1) and forming the metal contact regions (for example the regions 42-45 and 61, 62, 65 of Figure 1) of the electronic components 5, 7.

Furthermore, final manufacturing steps follow, here not shown, such as for example forming upper layers of metal interconnection and dicing the wafer, which lead to the formation of the device 1.

In practice, the use of the growth mask 103 allows the separation region 70 of Figure 1 to be formed. Therefore, the growth of the epitaxial multilayer 49 may give rise to low mechanical stress and therefore a reduced probability of dislocations. The manufacturing process therefore has high reliability.

Furthermore, the use of the growth mask 103 allows at the same time both to grow the epitaxial portion 106, which is monocrystalline, wherein the silicon-based electronic components 5 may be integrated, and to safeguard the surface quality of the upper surface 100A below the growth mask 103, on which the work multilayer 114 is grown.

Therefore, the manufacturing process allows to integrate in a same die both silicon-based electronic components 5 and heterostructure-based electronic components 7, while obtaining a high crystallographic quality of the heterostructure 50.

The fact that the growth mask 103 may be made of a different material (here for example of silicon oxide) with respect to the second intermediate layer 18 (here for example of silicon), in particular etchable through different chemical species with respect to those usable to remove the second intermediate layer 18, allows to form, through the sacrificial portion 107, the opening or recess 113 which exposes the underlying upper surface 100A without influencing, at least to a first approximation, the quality of the surface 100A on which to grow the work epitaxial multilayer 117 (Figures 3G-3J).

In practice, the growth mask 103 may be used as a stop layer during the etching of the overlying sacrificial portion 107, thus ensuring complete removal of the overlying sacrificial portion 107. Furthermore, the formation of the opening in the growth mask 103 does not affect the quality, for example in terms of terracing and pitting, of the underlying surface 100A.

The epitaxial multilayer 49, and therefore the heterostructure 50, may have a high crystallographic quality.

Consequently, the corresponding electronic components 7 whose functioning is based on the formation of the two-dimensional gas in the heterostructure 50 may have high electrical performances, in use.

At the same time, the electronic components 5 are also integrated in a monocrystalline silicon layer (epitaxial portion 106) which may have a high crystallographic quality. Consequently, the electronic components 5 may have high electrical performances, in use.

Furthermore, the thickness of the growth mask 103 may be sufficiently thick to be used as a mask for forming the epitaxial multilayer 49 and, at the same time, sufficiently thin to minimize the non-planarity of the upper surface 105A of the surface layer 105. In practice, the upper surface 105A of the surface layer 105 may be considered substantially planar. This allows the subsequent manufacturing steps, which lead to the formation of both the silicon-based electronic components 5 and the heterostructure-based electronic components 7, to be facilitated.

The possibility of using the substrate 14 of <111> oriented silicon as a starting substrate for forming the semiconductor electronic device 1 may allow a high epitaxial quality of the heterostructure 50 to be obtained, in particular when the channel layer 55 is of GaN or comprises GaN. Consequently, the heterostructure-based electronic components 7 may have excellent electrical performances. The Applicant has also verified that the use of the substrate 14 of <111> silicon also allows excellent electrical performances of the silicon-based electronic components 5 to be obtained.

With reference to the embodiment of the manufacturing process of Figures 3A-3O, the fact that some of the doped regions of the silicon-based devices 5, in particular the highly doped ones such as for example source regions, drain regions and body contact regions of the PMOS 5A and NMOS 5B transistors, may be formed after the growth of the epitaxial multilayer 49 may further contribute to increasing the reliability of the manufacture of the device 1.

In fact, the epitaxial multilayer 49 may be grown using a higher thermal budget than the one that may be withstood by the highly doped regions. In this manner, the highly doped regions of the silicon-based devices 5 may be formed with high reliability.

For example, the growth of the first buffer layer 52 of AlN may occur at a temperature of about 1100°C for a time interval comprised between about 15 and 30 minutes, and the growth of the GaN and AlGaN layers which form the second buffer layer 53, the channel layer 55, the barrier layer 56 and the channel modulation region 64 may occur in subsequent growth steps each at a temperature of about 1030°C-1080°C for an interval of about 5-15 minutes.

However, it will be clear to the person skilled in the art that the manufacturing steps described above and the respective order of execution may be different from what shown in Figures 3A-3O, according to the specific processes and machinery used.

For example, the epitaxial multilayer 49 may be grown after the formation of the highly doped regions, according to the specific materials which form the epitaxial multilayer 49 and the epitaxial region 23.

For example, the surface 105A may not be flat, for example according to the growth mode used to grow the layer 105, the thickness of the layer 102 and the surface treatments performed subsequently to the epitaxial growth (Chemical Mechanical Polishing, for example).

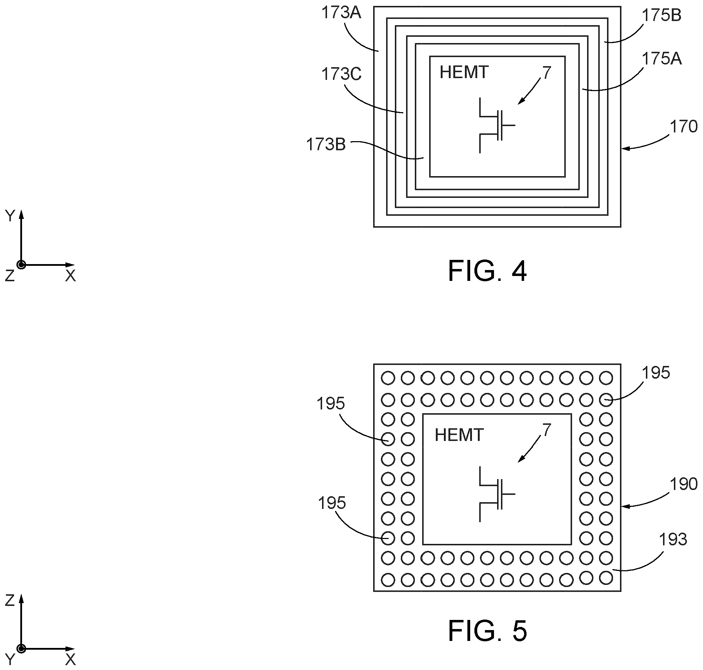

Figure 4 shows a different embodiment of the separation region, here indicated by 170. The separation region 170 comprises a polycrystalline region, here formed by three polycrystalline portions 173A, 173B, 173C, and two trenches 175A, 175B which extend, along the third axis Z, through the polycrystalline region.

Also in this embodiment, the polycrystalline portions 173A, 173B, 173C are separated from each other by the trenches 175A, 175B.

The trenches 175A, 175B are substantially concentric with each other and surround completely the epitaxial multilayer 49 wherein the HEMT transistor 7 is integrated.

The trenches 175A, 175B may each have a width, measured between two adjacent polycrystalline portions, comprised, for example, between 0.2 µm and 3 pm. The trenches 175A, 175B may extend at a distance one from the other comprised for example between 0.5 µm and 5 pm.

A higher number of trenches may contribute more to reducing the mechanical stress between the epitaxial multilayer 49 and the epitaxial region 23.

Figure 5 shows a further embodiment of the separation region, here indicated by 190, comprising a polycrystalline region, here formed by a plurality of polycrystalline portions 195; and a trench, here indicated by 193, which extends through the polycrystalline region and is delimited internally by the epitaxial multilayer 49 and externally by the epitaxial region 23 (here not shown).

In detail, the polycrystalline portions 195 are arranged at a distance one from the other within the trench 193. In practice, the polycrystalline portions 195 each form a polycrystalline pillar which extends, along the third axis Z, starting from the definition region 72.

The pillars 195 may each have a width, along the first axis X and/or the second axis Y, comprised for example between 0.5 µm and 5 pm. The pillars 195 may extend at a distance one from the other comprised, for example, between 0.2 µm and 3 pm.

The pillars 195 may have, along the third axis Z, a constant or variable section, for example of polygonal or circular shape (regular or non-regular).

The pillars 195 may be distributed around the multilayer 49 according to a regular or irregular distribution, according to the specific design layout.

In practice, the pillars 195 form mutually distinct portions of a polycrystalline region which extends alongside, in particular around, the epitaxial multilayer 49.

Finally, it is clear that other modifications and variations may be made to the electronic device 1 and the manufacturing process thereof described and illustrated herein, without thereby departing from the scope of the present invention, as defined in the attached claims.

The separation region 70 may have a different structure from what has been shown and described with reference to Figures 1-2 and 4, 5.

The trenches 75, 175A, 175B, 190 may only partially surround the epitaxial multilayer 49.

The trenches 75, 175A, 175B, 190 may extend, along the third axis Z, only partially through the polycrystalline region, i.e. so as not to be in contact with the definition region 72. In practice, in this case, the polycrystalline portions 73A, 73B of Figure 1, the polycrystalline portions 173A, 173B, 173C of Figure 4, and the polycrystalline portions 195 of Figure 5 are contiguous to each other and form a monolithic polycrystalline region.

In practice, the polycrystalline region of the separation regions 70, 170, 190 may be formed by one or more polycrystalline portions which are continuous or separate from each other. In other words, the polycrystalline region may be a single monolithic region or a discontinuous region.

The trenches 175A, 175B, 190 may be empty or filled (partially or completely), similarly to what has been discussed for the trench 75 of Figure 1. Furthermore, the possible filling of the trenches 175A, 175B, 190 may be uniform or non-uniform around the epitaxial multilayer 49, according to the specific manufacturing steps used.

The electronic device 1 may only comprise heterostructure-based electronic components 7, and not the silicon-based electronic components 5. The presence of the separation region, in particular of the respective polycrystalline region, contributes to reducing the mechanical stress caused by the growth of the epitaxial multilayer 49 and therefore allows a good crystallographic quality of the heterostructure 50.

The electronic device 1 may comprise, additionally or alternatively to the PMOS 5A and NMOS 5B transistors, other silicon-based electronic components 5, active and/or passive, integrated in the die 3.

For example, as shown in Figure 2, the silicon-based electronic components 5 may also include bipolar transistors 5C and passive components 5D such as diodes and resistors. In Figure 2, the bipolar transistors 5C and the passive components 5D are integrated in respective device portions 120, 121 distinct from each other and indicated schematically by a dashed line.

For example, the device portions 120, 121 are formed in respective monocrystalline silicon epitaxial regions grown on the substrate region 10, in particular monolithic with the epitaxial region 23.

Insulation regions, for example shallow or deep trenches, may be arranged, in a per se know manner, between the portions 120, 121 and 20, so that the respective electronic components are, in use, electrically insulated from each other.

With reference to Figure 1, the insulation region 82 that extends between the first and the second device portions 20, 21 may have different shape and structure from what has been shown. For example, it may comprise one or more trenches extending along the third axis Z to a greater depth in the die 3, within the epitaxial region 23, so as to electrically insulate from each other the portion of the substrate region 10 that is arranged below the device portion 21 wherein the HEMT transistor 7 is integrated from the portion of the substrate region 10 that is arranged below the device portion 20 wherein the PMOS 5A and NMOS 5B transistors are integrated.

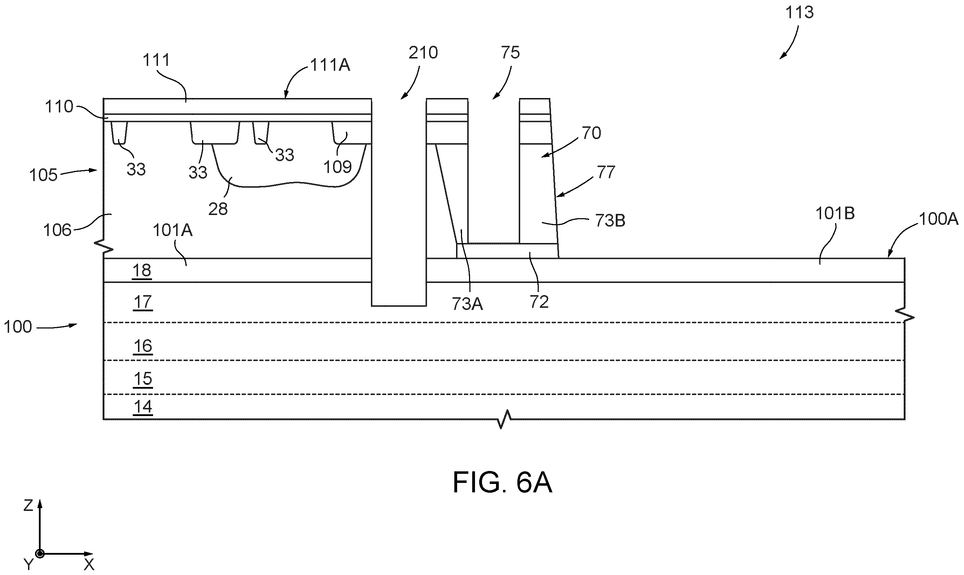

The formation of such deep insulation trenches may be integrated in the manufacturing process described with reference to Figures 3A-3O. For example, Figure 6A shows a cross-section of the wafer 100, after the manufacturing step of Figure 3H.

In the wafer 100 of Figure 6A, a deep insulation trench 210 is formed in the wafer 100, in particular within the epitaxial portion 106 of the surface layer 105 and, partially, within the substrate region 10.

In this embodiment, the deep insulation trench 210 is formed simultaneously with the trench 75, thus optimizing the number of lithography and etching steps.

The deep insulation trench 210 and the trench 75 may be formed simultaneously, even if the deep insulation trench 210 and the trench 75 have, along the third axis Z, different depths within the wafer 100. In fact, the definition region 72 works as a stop layer during the etching of the work polycrystalline region 114. Consequently, by modulating the etching time it is possible to modulate the depth of the deep insulation trench 210, without compromising the formation of the trench 75.

However, the deep insulation trench 210 may be formed through dedicated lithography and etching steps, i.e. separate (preceding or subsequent) with respect to those used to form the trench 75.

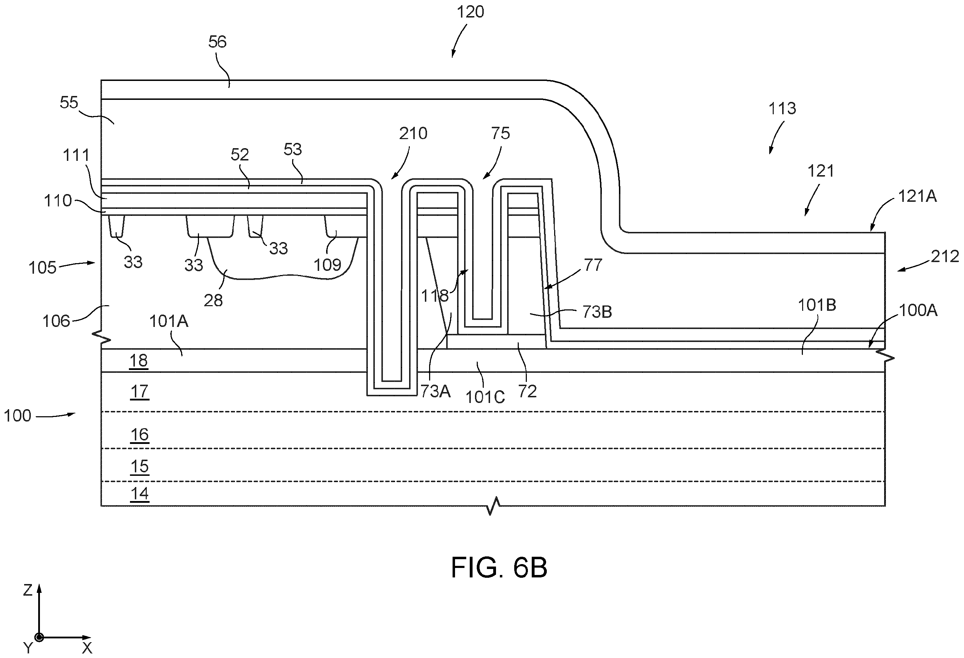

Subsequently, Figure 6B, the work epitaxial multilayer, here indicated by 212, is grown. In this embodiment, the work epitaxial multilayer 212 grows conformally both within the trench 75 and within the deep insulation trench 210.

The device 1 may also comprise other silicon-based electronic components 5 integrated in the die 3, in addition to or in lieu of those shown in Figure 2. For example, the components 5 may include MOS transistors for medium voltage applications, for example from 15 V to 20 V; DMOS transistors and/or drift MOS transistors, for example for applications at operating voltages from 20V to 200V; thin film resistors; OTP or MTP memories; phase change memories; etc.

It will be clear to the person skilled in the art that the integration of silicon-based electronic components 5 of types different from each other may be performed through manufacturing steps which are per se known and therefore not further shown here, for example through BCD technology.

For example, the conductivity type, n or p, of the various semiconductive regions may be inverted with respect to what has been described.

The epitaxial multilayer 49 may comprise a different number of layers from what has been shown and described.

For example, the epitaxial multilayer 49 may comprise only the heterostructure 50. In other words, the heterostructure 50 may be grown directly on the substrate region 10.

The heterostructure 50 may comprise other semiconductive and/or insulating layers, for example between the channel layer 55 and the barrier layer 56, according to the specific application.

For example, the heterostructure-based components 7 may include electronic components other than the HEMT transistor 7.

For example, the HEMT transistor 7 may be of normally-off type, wherein the gate structure may be different from what has been previously described; for example, the gate structure may be of recess type and/or the manufacture of the gate structure may include the use of fluorine plasma under the gate structure. Alternatively, the HEMT transistor 7 may be of normally-on type, i.e. of the depletion type.

For example, the number of epitaxial layers which form the substrate region 10 may be different, according to the specific application.

For example, the growth of the work multilayer 114, 212 may be different from what has been described with reference to Figures 3J and 6B, depending on the specific growth parameters used.

Consequently, the shape of the epitaxial multilayer 49 may be different from what has been shown in Figure 1. For example, the peripheral portion 84 may not be conformal to the inner side wall 77.

For example, the multilayer 114 may selectively grow only starting from the exposed portion 101B of the second intermediate layer 18. In this case, the removal step described with reference to Figure 3M may be absent.

For example, as a function of the desired thicknesses along the third axis Z, of the epitaxial multilayer 49 and of the epitaxial region 23, the second intermediate layer 18 may be absent and the epitaxial multilayer 49 may be grown directly on the second deep layer 17.

In case of medium or low voltage applications (for example from 7 V to 40 V) the substrate region 10 may comprise only the substrate 14 and the first deep layer 15 (or also the first intermediate layer 16). In practice, in this case, the epitaxial multilayer 49 may be grown directly on the first deep layer 15 or, if any, on the first intermediate layer 16.

In practice, in summary, in the present semiconductor electronic device, the substrate region 10 may comprise the monocrystalline substrate 14 having a first conductivity type (for example, P) and at least one epitaxial layer (15-18) which extends on the substrate and has a conductivity type (for example, N) different from that of the substrate.

For example, the electronic components 5 may be electronic components based on a single semiconductor other than silicon, for example Ge, SiGe, etc.

The embodiments described above may be combined to provide further solutions.

## Claims

1. A semiconductor electronic device (1) comprising:
a substrate region (10) of semiconductor material;
a first electronic component (7) based on heterostructure, comprising an epitaxial multilayer (49) that extends on the substrate region and includes a heterostructure (50);
a separation region (70; 170; 190) that extends on the substrate region and includes a polycrystalline region (73A, 73B; 173A, 173B, 173C; 195) of semiconductor material of polycrystalline type which is arranged, along a first direction (X, Y), alongside the epitaxial multilayer; and
an epitaxial region (23) of a single semiconductor material of monocrystalline type extending on the substrate region (10),
the polycrystalline region (73A, 73B; 173A, 173B, 173C; 195) extending, along the first direction (X), between the epitaxial multilayer (49) and the epitaxial region (23).

2. The semiconductor electronic device according to the preceding claim, further comprising a second electronic component (5) based on the single semiconductor material and integrated into the epitaxial region (23), the second electronic component being for example one of: a CMOS transistor, a DMOS transistor, a bipolar transistor or a passive electronic component based on single semiconductor material.

3. The semiconductor electronic device according to any of the preceding claims, wherein the separation region (70; 170; 190) comprises at least one trench (75; 175A, 175B, 195) extending in the polycrystalline region.

4. The electronic device according to the preceding claim, wherein the polycrystalline region comprises a plurality of portions (73A, 73B; 173A, 173B, 173C; 195) distinct from each other and separated by the at least one trench.

5. The electronic device according to the preceding claim, wherein two adjacent portions (73A, 73B; 173A, 173B, 173C; 195) of the polycrystalline region extend at a mutual distance comprised between 0.2 µm and 3 pm.

6. The electronic device according to claim 4 or 5, wherein the portions (195) of the polycrystalline region are each a pillar having a width comprised between 0.5 µm and 5 pm.

7. The semiconductor electronic device according to any of the preceding claims, wherein the separation region further comprises a definition region (72) comprising an oxide and extending between the substrate region (10) and the polycrystalline region.

8. The semiconductor electronic device according to the preceding claim, wherein the definition region (72) has a thickness comprised between 7 nm and 300 nm.

9. The semiconductor electronic device according to any of the preceding claims, wherein the separation region (70; 170; 190) surrounds, at least in part, the epitaxial multilayer (49).

10. The semiconductor electronic device according to any of the preceding claims, wherein the epitaxial region (23) is of a first semiconductor material, for example silicon, and the heterostructure (50) comprises a second semiconductor material, for example GaN, different from the first semiconductor material.

11. A process for manufacturing a semiconductor electronic device (1), comprising:
providing a wafer (100) comprising a substrate layer (18) of semiconductor material having a first growth portion (101B) and a second growth portion (101C) distinct from the first growth portion;
growing, on the first growth portion, an epitaxial multilayer (49) comprising a heterostructure (50);
forming a first electronic component (7) based on heterostructure, starting from the heterostructure;
forming, on the second growth portion, a separation region (70; 170; 190) including a polycrystalline region (73A, 73B; 173A, 173B, 173C; 195) of semiconductor material of polycrystalline type which is arranged, along a first direction (X, Y), alongside the epitaxial multilayer; and
forming an epitaxial region (23) of a single semiconductor material of monocrystalline type extending on the substrate layer (18),
the polycrystalline region (73A, 73B; 173A, 173B, 173C; 195) extending, along the first direction (X), between the epitaxial multilayer (49) and the epitaxial region (23).

12. The manufacturing process according to the preceding claim, wherein the substrate layer comprises a third growth portion (101A) distinct from the first and the second growth portions, further comprising:
forming, on the substrate layer, a growth mask (103) which covers the first growth portion (101B) and the second growth portion (101C) of the substrate layer;
growing a surface layer (105) of a single semiconductor material having a monocrystalline portion (106) extending on the third growth portion (101A) of the substrate layer and a polycrystalline portion (107) extending on the growth mask, the polycrystalline region of the separation region being formed starting from the polycrystalline portion of the surface layer, the epitaxial region being formed starting from the monocrystalline portion of the surface layer; and
forming, before growing the epitaxial multilayer (117; 212), in the polycrystalline portion (107) of the surface layer (105) and in the growth mask (103), an opening (113) which exposes the first growth portion (101B) of the substrate layer.

13. The manufacturing process according to the preceding claim, further comprising forming a second electronic component (5) based on a single semiconductor material, integrated into the monocrystalline portion (106) of the surface layer (105).

14. The manufacturing process according to any of claims 11-13, wherein forming the separation region (70; 170; 190) comprises forming at least one trench (75; 175A, 175B, 195) through the polycrystalline portion (107) of the surface layer (105), over the third growth portion (101C) of the substrate layer (18).

15. The manufacturing process according to the preceding claim, wherein the trench (75) is formed before growing the epitaxial multilayer.
